# FASCICULE DE BREVET EUROPEEN

(11) **EP 3 769 162 B1**
(45) Date de publication et mention de la délivrance du brevet: **10.08.2022**
(21) Numéro de dépôt: 19717200.0
(22) Date de dépôt: 19.03.2019
(51) Int. Cl.: G04B 17/06, G04B 17/22

(54) **PROCEDE DE FABRICATION DE COMPOSANTS HORLOGERS EN SILICIUM**
HERSTELLUNGSVERFAHREN VON UHRKOMPONENTEN AUS SILIZIUM
METHOD FOR MANUFACTURING SILICON CLOCK COMPONENTS

(30) Priorité: 20.03.2018 EP 18162729
(43) Date de publication de la demande: 27.01.2021
(60) Demande divisionnaire: 21182494.1
(73) Titulaire: Patek Philippe SA Genève, 1204 Genève (CH)
(72) Inventeur: JEANNERET, Sylvain, 2013 Colombier (CH)
(74) Mandataire: Micheli & Cie SA
(86) Numéro de dépôt international: PCT/IB2019/052198
(87) Numéro de publication internationale: WO 2019/180596

(56) Documents cités:
- EP-A1- 2 799 939
- EP-A1- 3 181 938
- WO-A1-2010/057777
- WO-A1-2016/128694
- US-A- 4 400 861

## Description

La présente invention porte sur un procédé de fabrication de composants horlogers, tels que des spiraux, des ancres, des roues, des aiguilles, des bascules, des leviers, des ressorts ou des balanciers, en silicium.

Des procédés de fabrication de composants horlogers en silicium ont été décrits notamment dans les documents EP 0732635, EP 1422436, EP 2215531 et EP 3181938.

La présente invention vise à proposer un procédé permettant de fabriquer des composants horlogers en silicium de grande qualité.

A cette fin il est prévu un procédé selon la revendication 1 ou la revendication 2 et les revendications qui en dépendent.

D'autres caractéristiques et avantages de la présente invention apparaîtront à la lecture de la description détaillée suivante faite en référence aux dessins annexés dans lesquels :
- les figures 1 à 11 montrent schématiquement des étapes successives d'un procédé selon un mode de réalisation particulier de l'invention ;
- les figures 12 et 13 sont respectivement une vue en perspective et une vue de profil d'un organe de support utilisé dans le procédé selon le mode de réalisation particulier de l'invention pour supporter une plaquette de silicium pendant un traitement d'oxydation thermique de cette dernière ;
- les figures 14 et 15 montrent schématiquement une étape du procédé selon le mode de réalisation particulier de l'invention, dans laquelle une plaquette de silicium gravée est libérée d'un substrat composite ;
- la figure 16 montre un substrat composite à partir duquel peut être mis en œuvre un procédé selon un autre mode de réalisation de l'invention.

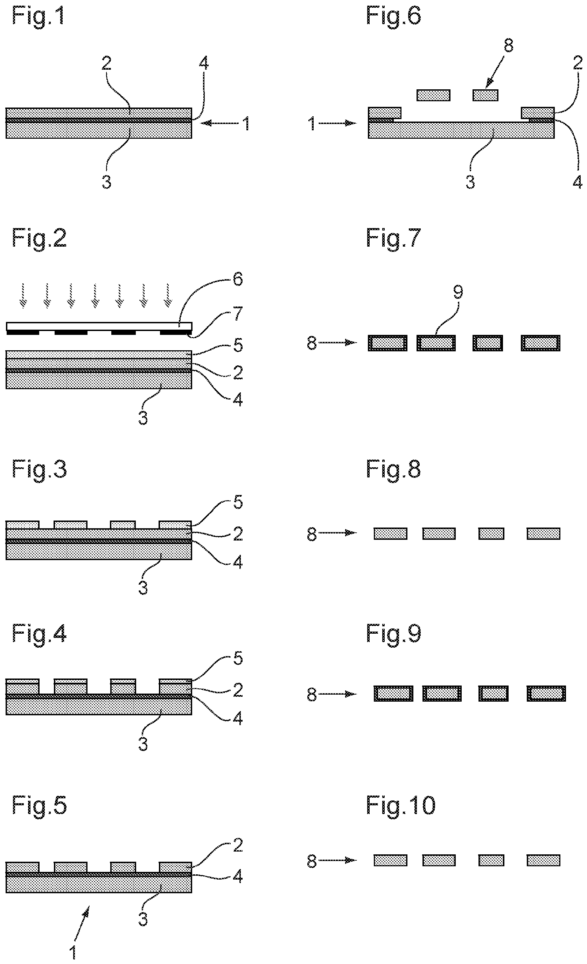

Un procédé de fabrication de composants horlogers en silicium, notamment pour montres-bracelets, comprend selon un mode de réalisation particulier de l'invention les étapes successives illustrées aux figures 1 à 11.

A une première étape (figure 1), on se munit d'un substrat 1 de type silicium sur isolant connu sous l'acronyme SOI (Silicon-On-Insulator). Le substrat 1 comprend une couche supérieure de silicium 2, une couche inférieure de silicium 3 et, entre les deux, une couche intermédiaire d'oxyde de silicium 4. Le silicium est monocristallin, polycristallin ou amorphe. Il peut être dopé ou non. L'épaisseur de la couche supérieure de silicium 2 est choisie en fonction de l'épaisseur des composants que l'on souhaite réaliser. La couche inférieure de silicium 3 sert à conférer au substrat 1 une rigidité suffisante facilitant sa manipulation et la mise en oeuvre des opérations qui vont être décrites ci-dessous.

A une deuxième étape (figure 2), on dépose sur la couche supérieure de silicium 2 une couche de laque photosensible 5 et on structure cette couche 5 par photolithographie. Plus précisément, on expose la couche de laque photosensible 5 à des rayons ultra-violets à travers un masque 6, typiquement en verre ou en quartz, portant une structure 7, typiquement en chrome, à transférer. Puis la couche de laque photosensible 5 est développée et cuite (figure 3). A l'issue de ces opérations, la couche de laque photosensible 5 présente la même forme que la structure 7 et constitue à son tour un masque, ladite forme correspondant à celle d'un lot de composants horlogers à fabriquer.

A une étape suivante (figure 4), on grave la couche supérieure de silicium 2 à travers le masque de laque photosensible 5 par gravure ionique réactive profonde dite DRIE (Deep Reactive Ion Etching) afin de former dans cette couche 2 les composants horlogers. La gravure est arrêtée par la couche intermédiaire d'oxyde de silicium 4, permettant ainsi de définir une épaisseur précise pour les composants horlogers. Les paramètres de gravure peuvent être ajustés en fonction des composants, pour obtenir des caractéristiques particulières en termes par exemple de rugosité ou d'angle des flancs. Les composants horlogers formés dans la couche supérieure de silicium 2 sont de préférence identiques mais ils pourraient en variante être répartis en plusieurs groupes, chaque groupe correspondant à un type de composant. Les composants horlogers comprennent par exemple au moins l'un des types de composants suivants : spiraux, ancres, roues, notamment roues d'échappement, aiguilles, bascules, leviers, ressorts, balanciers, ou des parties de tels composants. Le procédé selon l'invention convient particulièrement à des composants d'organe réglant et plus généralement à des composants de mouvement horloger nécessitant une faible masse et/ou une faible inertie.

Le masque de laque photosensible 5 est ensuite éliminé par gravure chimique ou gravure plasma (figure 5).

A une étape suivante (figure 6), on libère du substrat 1, d'une manière qui sera décrite plus loin, une plaquette 8 formée par au moins tout ou partie de la couche supérieure de silicium 2 gravée. Cette plaquette 8 contient une structure de base et les composants horlogers attachés à la structure de base par des ponts de matière laissés lors de la gravure.

Puis la plaquette 8 est placée dans un four d'oxydation pour être soumise à un traitement thermique, typiquement entre 600°C et 1300°C, oxydant toute la surface extérieure des composants horlogers (figure 7). La couche d'oxyde de silicium (SiO₂) 9 qui recouvre alors la plaquette 8 et en particulier les composants horlogers se forme en consommant du silicium de la plaquette 8, ce qui fait reculer l'interface entre le silicium et l'oxyde de silicium et atténue les défauts de surface du silicium. En éliminant ensuite l'oxyde de silicium (figure 8), par gravure humide, gravure en phase vapeur ou gravure sèche, on obtient des composants horlogers ayant un bon état de surface. En particulier, la rugosité des flancs due à la gravure DRIE et les défauts cristallins de surface sont fortement réduits.

A ce stade du procédé, on peut mesurer des caractéristiques physiques des composants horlogers ou de certains d'entre eux, notamment leurs dimensions. Grâce à l'étape précédente d'oxydation - désoxydation, ces caractéristiques physiques sont bien définies et leur mesure peut donc être précise, n'étant pas perturbée par les défauts de surface. Dans le cas de spiraux, on peut déterminer leur raideur. Pour un spiral donné, la raideur peut être déterminée en couplant le spiral, alors qu'il est encore attaché à la plaquette 8 ou détaché de la plaquette 8, à un balancier d'inertie prédéterminée, en mesurant la fréquence de l'ensemble balancier-spiral et en déduisant de cette mesure, par calcul, la raideur du spiral. On peut plus particulièrement mettre en oeuvre le procédé décrit dans la demande de brevet EP 3181938, à savoir déterminer la raideur des spiraux, calculer une épaisseur de matériau à retirer des spiraux pour obtenir une raideur souhaitée, puis retirer cette épaisseur de matériau afin d'obtenir des spiraux de la raideur souhaitée. Pour retirer ladite épaisseur de matériau, on peut oxyder thermiquement la plaquette 8 et ses composants horlogers (figure 9) puis la désoxyder (figure 10), de la même manière que décrit précédemment en référence aux figures 7 et 8. Les opérations de détermination de la raideur, de calcul de l'épaisseur à retirer et de retrait de cette épaisseur par oxydation - désoxydation peuvent être répétées si nécessaire pour affiner la précision dimensionnelle des spiraux.

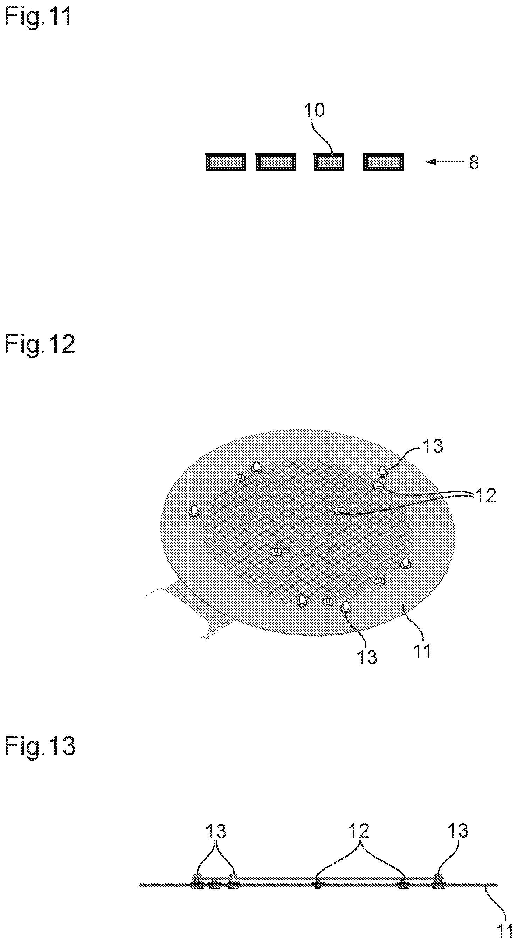

A encore une autre étape du procédé (figure 11), une couche d'oxyde de silicium (SiO₂) 10 est formée sur la plaquette 8 et ses composants horlogers, par exemple par oxydation thermique ou par dépôt chimique ou physique en phase vapeur (CVD, PVD). Cette couche d'oxyde de silicium 10 qui enrobe les composants horlogers renforce leur résistance mécanique. Dans le cas d'un spiral, la couche d'oxyde de silicium 10 a une épaisseur qui lui permet de compenser les variations en fonction de la température du module d'élasticité de l'âme en silicium ainsi que les variations en fonction de la température du moment d'inertie du balancier que le spiral est destiné à équiper, afin que la fréquence de l'oscillateur balancier-spiral soit insensible à la température, comme décrit dans les brevets EP 1422436 et EP 2215531.

A une étape finale, les composants horlogers sont détachés de la structure de base de la plaquette 8.

Durant les étapes d'oxydation (figures 7 et 9 et, le cas échéant, figure 11), la plaquette 8 est de préférence supportée horizontalement par une plaque de support 11 telle qu'illustrée aux figures 12 et 13, pouvant être manipulée manuellement ou par un robot. Cette plaque de support 11 est dans un matériau compatible avec le traitement d'oxydation, par exemple le quartz, le silicium ou le carbure de silicium. Pour permettre une oxydation homogène de la plaquette 8, cette dernière est surélevée par rapport à la plaquette de support 11 par des entretoises 12 qui soutiennent la plaquette 8 dans des zones qui ne contiennent pas de composants (notamment entre les composants). La plaquette 8 est empêchée de bouger horizontalement par des éléments de retenue 13 coopérant avec le pourtour de la plaquette 8. Les entretoises 12 et les éléments de retenue 13 sont de forme générale cylindrique. Ils sont solidaires de la plaque de support 11, par exemple fixés à la plaque de support 11 par des liaisons de type baïonnette. Ils sont réalisés par exemple en quartz ou en carbure de silicium, et peuvent être dans le même matériau ou dans des matériaux différents. Dans un exemple de réalisation préféré, la plaque de support 11 est en silicium et les entretoises et éléments de retenue 12, 13 sont en quartz. Une telle plaque de support 11 avec ses entretoises 12 et éléments de retenue 13 peut aussi être utilisée pendant l'étape de la figure 11 lorsque celle-ci consiste en une opération de dépôt CVD ou PVD.

De préférence, durant le traitement d'oxydation de la figure 9, la plaquette 8 est placée sur la plaque de support 11 dans une position retournée par rapport au traitement d'oxydation de la figure 7. De même, durant le traitement d'oxydation ou de dépôt de la figure 11, la plaquette 8 est placée sur la plaque de support 11 dans une position retournée par rapport au traitement d'oxydation de la figure 9. Ceci permet d'éviter que des déformations permanentes se produisent dans les composants horlogers sous l'effet de la pesanteur et de la chaleur, ou d'au moins limiter ces déformations.

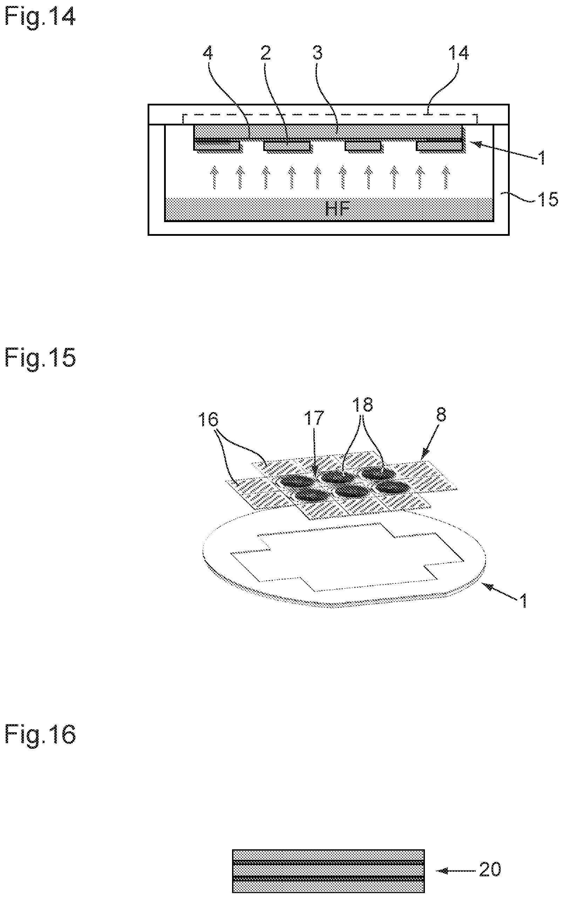

L'étape de libération de la plaquette 8 du substrat 1 (figure 6) peut être mise en œuvre par élimination de toute la couche inférieure de silicium 3 et de toute la couche intermédiaire d'oxyde de silicium 4 par gravure chimique ou gravure plasma. On peut aussi retirer la couche inférieure de silicium 3 et la couche intermédiaire d'oxyde de silicium 4 seulement au dos des composants ou des groupes de composants, la plaquette 8 gardant alors une partie de ces couches 3, 4. Toutefois, ces opérations sont longues et coûteuses. Dans la présente invention, de préférence, la plaquette 8 est formée par une partie de la couche supérieure de silicium 2 et sa libération du substrat 1 est mise en œuvre de la manière exposée ci-dessous et illustrée aux figures 14 et 15.

On fixe le substrat 1 gravé tel que montré à la figure 5 contre un élément chauffant 14 dans une chambre fermée 15 (figure 14), la couche supérieure de silicium 2 étant orientée vers le bas, la couche inférieure de silicium 3, orientée donc vers le haut, étant contre l'élément chauffant 14. Le mode de fixation du substrat 1 contre l'élément chauffant 14 peut être électrostatique (par application d'un champ électrique) ou mécanique. Une solution d'acide fluorhydrique (HF) est ajoutée dans la chambre 15, hors de contact avec le substrat 1. Les vapeurs de l'acide fluorhydrique qui saturent alors l'intérieur de la chambre 15 gravent la couche intermédiaire d'oxyde de silicium 4, sans attaquer le silicium. L'élément chauffant 14, régulé en température, empêche la condensation de l'eau produite par la réaction entre l'acide fluorhydrique et l'oxyde de silicium, condensation qui provoquerait un collage entre la partie à libérer et le reste du substrat 1.

La partie à libérer, à savoir la plaquette 8, est définie préalablement par une saignée réalisée lors de la gravure de la couche supérieure de silicium 2 et qui forme le pourtour de la plaquette 8. Pendant cette même gravure de la couche supérieure de silicium 2, des ouvertures 16, par exemple en forme de hachures comme représenté à la figure 15, sont gravées dans la plaquette 8 autour d'une zone centrale 17 comprenant les composants. Ces ouvertures 16 permettent le passage de la vapeur d'acide fluorhydrique.

La figure 15 montre un exemple de plaquette 8 ayant une forme constituée de parties rectangulaires ou carrées. D'autres formes peuvent bien sûr être envisagées, par exemple la forme circulaire. A la figure 15 on peut voir les composants horlogers 18 portés par la plaquette 8, ici constitués de spiraux. Ces composants horlogers ont été représentés en nombre réduit par rapport à leur nombre réel, afin de faciliter la lecture du dessin.

Les composants horlogers fabriqués par le procédé selon l'invention peuvent avoir des dimensions très précises et de bons états de surface qui amélioreront la précision de fonctionnement et le rendement des mécanismes qui les utiliseront.

Des modifications du procédé selon l'invention tel que décrit ci-dessus sont bien entendu possibles.

Par exemple, bien que les deux étapes d'oxydation - désoxydation (figures7, 8 et figures 9, 10) pour respectivement améliorer l'état de surface des composants horlogers et ajuster leur raideur (dans le cas de spiraux) soient particulièrement avantageuses, on pourrait n'en prévoir qu'une, à la fois pour améliorer l'état de surface et ajuster la raideur, que précéderait une étape de détermination de la raideur.

On pourrait aussi partir d'un substrat double ou triple SOI, voire plus, c'est-à-dire d'un substrat comprenant plus de deux couches de silicium séparées par des couches intermédiaires d'oxyde de silicium, comme le substrat 20 montré à la figure 16, et graver les composants horlogers dans un groupe de couches supérieures qui serait ensuite libéré du substrat. Les composants horlogers auraient alors une structure composite comprenant une ou plusieurs couches intermédiaires d'oxyde de silicium.

Le masque de laque photosensible 5 qui sert à structurer la couche supérieure de silicium 2 (figure 3) pourrait être remplacé par un masque d'oxyde de silicium. On pourrait aussi associer un masque de laque photosensible et un masque d'oxyde de silicium pour réaliser par gravure dans la couche supérieure de silicium ou dans un groupe de couches supérieures des composants horlogers multiniveaux.

Dans d'autres variantes, on pourrait graver le substrat depuis ses deux faces.

La ou les couches d'oxydes de silicium servant à arrêter la gravure pourraient être renforcées par une ou des couches de type parylène.

Enfin, la présente invention n'exclut pas non plus l'utilisation d'une ou plusieurs couches métalliques pour arrêter la gravure.

## Revendications

1. Procédé de fabrication de composants horlogers comprenant les étapes suivantes :
a) se munir d'un substrat (1) comprenant une première couche de silicium (2), une deuxième couche de silicium (3) et, entre les deux, une couche intermédiaire d'oxyde de silicium (4),
b) graver la première couche de silicium (2) afin d'y former les composants horlogers,
c) libérer du substrat (1) une plaquette (8) formée par au moins tout ou partie de la première couche de silicium (2) gravée et comprenant les composants horlogers,
d) oxyder thermiquement puis désoxyder les composants horlogers,
e) former par oxydation thermique ou dépôt une couche d'oxyde de silicium (10) sur les composants horlogers, et
f) détacher les composants horlogers de la plaquette (8).

2. Procédé de fabrication de composants horlogers comprenant les étapes suivantes :
a) se munir d'un substrat (20) comprenant des couches de silicium intercalées avec des couches d'oxyde de silicium,
b) graver un groupe de couches du substrat afin d'y former les composants horlogers,
c) libérer du substrat une plaquette formée par au moins tout ou partie du groupe de couches et comprenant les composants horlogers,
d) oxyder thermiquement puis désoxyder les composants horlogers,
e) former par oxydation thermique ou dépôt une couche d'oxyde de silicium sur les composants horlogers, et
f) détacher les composants horlogers de la plaquette.

3. Procédé selon la revendication 1 ou 2, dans lequel la gravure à l'étape b) comprend une gravure ionique réactive profonde.

4. Procédé selon l'une des revendications 1 à 3, comprenant entre les étapes d) et e) une étape supplémentaire consistant à oxyder thermiquement puis désoxyder les composants horlogers.

5. Procédé selon la revendication 4, dans lequel l'étape d) sert à améliorer l'état de surface des composants horlogers et ladite étape supplémentaire sert à ajuster la raideur de spiraux constituant les composants horlogers.

6. Procédé selon la revendication 4 ou 5, dans lequel durant l'opération d'oxydation thermique de ladite étape supplémentaire la plaquette (8) est dans une position retournée par rapport à l'opération d'oxydation thermique de l'étape d).

7. Procédé selon l'une des revendications 4 à 6, dans lequel durant l'étape e) la plaquette (8) est dans une position retournée par rapport à l'opération d'oxydation thermique de ladite étape supplémentaire.

8. Procédé selon l'une des revendications 1 à 7, dans lequel durant la ou les opérations d'oxydation thermique, la plaquette (8) est supportée par un organe de support (11, 12, 13) comprenant une plaque de support (11) et des entretoises (12) et éléments de retenue (13) portés par la plaque de support (11), les entretoises (12) maintenant un écartement entre la plaquette (8) et la plaque de support (11), les éléments de retenue (13) empêchant la plaquette (8) de bouger horizontalement.

9. Procédé selon la revendication 8, dans lequel les entretoises (12) supportent la plaquette (8) dans des zones de la plaquette (8) ne comprenant pas de composant horloger.

10. Procédé selon la revendication 8 ou 9, dans lequel la plaque de support (11) est en silicium, quartz ou carbure de silicium.

11. Procédé selon l'une des revendications 8 à 10, dans lequel les entretoises (12) et les éléments de retenue (13) sont en quartz ou carbure de silicium.

12. Procédé selon l'une des revendications 8 à 11, dans lequel les entretoises (12) et les éléments de retenue (13) sont fixés à la plaque de support (11) par des liaisons de type baïonnette.

13. Procédé selon l'une des revendications 1 et 3 à 12, dans lequel l'étape c) comprend une opération de gravure sous phase vapeur de la couche intermédiaire d'oxyde de silicium (4).

14. Procédé selon l'une des revendications 1 et 3 à 13, dans lequel la plaquette (8) libérée à l'étape c) est formée par une partie de la première couche de silicium (2) gravée.

15. Procédé selon l'une des revendications 1 et 3 à 14, dans lequel à l'étape b) une saignée est gravée dans la première couche de silicium (2) pour définir le pourtour de la plaquette (8) à libérer lors de l'étape c).

16. Procédé selon l'une des revendications 1 et 3 à 15, dans lequel à l'étape b) des ouvertures (16) sont gravées dans la première couche de silicium (2) autour d'une zone centrale (17) où sont gravés les composants horlogers (18), ces ouvertures (16) permettant le passage d'un agent de gravure de la couche intermédiaire d'oxyde de silicium (4) pendant l'étape c).

17. Procédé selon l'une des revendications 1 à 16, dans lequel les composants horlogers comprennent au moins l'un des types suivants de composants : spiraux (18), ancres, roues, aiguilles, bascules, leviers, ressorts, balanciers, ou des parties de tels composants.

## Patentansprüche

1. Verfahren zur Herstellung von Uhrenkomponenten, das die folgenden Schritte umfasst:
a) Bereitstellen eines Substrats (1), das eine erste Siliziumschicht (2), eine zweite Siliziumschicht (3) und zwischen den beiden eine Siliziumoxid-Zwischenschicht (4) umfasst,
b) Ätzen der ersten Siliziumschicht (2), um die Uhrenkomponenten darin zu bilden,
c) Befreien eines Plättchens (8), das aus mindestens der gesamten geätzten ersten Siliziumschicht (2) oder einem Teil davon gebildet ist und die Uhrenkomponenten umfasst, von dem Substrat (1),
d) thermisches Oxidieren und dann Desoxidieren der Uhrenkomponenten,
e) Bilden einer Siliziumoxidschicht (10) auf den Uhrenkomponenten durch thermische Oxidation oder Abscheiden, und
f) Lösen der Uhrenkomponenten von dem Plättchen (8).

2. Verfahren zur Herstellung von Uhrenkomponenten, das die folgenden Schritte umfasst:
a) Bereitstellen eines Substrats (20), das mit Siliziumoxidschichten verschachtelte Siliziumschichten umfasst,
b) Ätzen einer Gruppe von Schichten des Substrats, um darin die Uhrenkomponenten zu bilden,
c) Befreien eines Plättchens, das aus mindestens der gesamten Gruppe von Schichten oder einem Teil davon gebildet ist und die Uhrenkomponenten umfasst, von dem Substrat,
d) thermisches Oxidieren und dann Desoxidieren der Uhrenkomponenten,
e) Bilden einer Siliziumoxidschicht auf den Uhrenkomponenten durch thermische Oxidation oder Abscheiden, und
f) Lösen der Uhrenkomponenten von dem Plättchen.

3. Verfahren nach Anspruch 1 oder 2, wobei das Ätzen im Schritt b) ein reaktives Ionentiefenätzen umfasst.

4. Verfahren nach einem der Ansprüche 1 bis 3, das zwischen den Schritten d) und e) einen zusätzlichen Schritt umfasst, der darin besteht, die Uhrenkomponenten thermisch zu oxidieren und dann zu desoxidieren.

5. Verfahren nach Anspruch 4, wobei der Schritt d) dazu dient, den Oberflächenzustand der Uhrenkomponenten zu verbessern, und der zusätzliche Schritt dazu dient, die Steifigkeit von Spiralen anzupassen, aus denen die Uhrenkomponenten bestehen.

6. Verfahren nach Anspruch 4 oder 5, wobei während des Vorgangs der thermischen Oxidation des zusätzlichen Schritts das Plättchen (8) sich in einer in Bezug auf den Vorgang der thermischen Oxidation des Schritts d) umgedrehten Position befindet.

7. Verfahren nach einem der Ansprüche 4 bis 6, wobei während des Schritts e) das Plättchen (8) sich in einer in Bezug auf den Vorgang der thermischen Oxidation des zusätzlichen Schritts umgedrehten Position befindet.

8. Verfahren nach einem der Ansprüche 1 bis 7, wobei während des oder den Vorgängen der thermischen Oxidation das Plättchen (8) von einem Stützorgan (11, 12, 13) gestützt wird, das eine Stützplatte (11) und Querstreben (12) und Rückhalteelemente (13) umfasst, die von der Stützplatte (11) getragen werden, wobei die Querstreben (12) einen Abstand zwischen dem Plättchen (8) und der Stützplatte (11) halten, wobei die Rückhalteelemente (13) das Plättchen (8) daran hindern, sich horizontal zu bewegen.

9. Verfahren nach Anspruch 8, wobei die Querstreben (12) das Plättchen (8) in Zonen des Plättchens (8) stützen, die keine Uhrenkomponente umfassen.

10. Verfahren nach Anspruch 8 oder 9, wobei die Stützplatte (11) aus Silizium, Quarz oder Siliziumcarbid ist.

11. Verfahren nach einem der Ansprüche 8 bis 10, wobei die Querstreben (12) und die Rückhalteelemente (13) aus Quarz oder Siliziumcarbid sind.

12. Verfahren nach einem der Ansprüche 8 bis 11, wobei die Querstreben (12) und die Rückhalteelemente (13) durch Verbindungen vom Bajonetttyp an der Stützplatte (11) befestigt sind.

13. Verfahren nach einem der Ansprüche 1 und 3 bis 12, wobei der Schritt c) einen Vorgang des Gasphasenätzens der Siliziumoxid-Zwischenschicht (4) umfasst.

14. Verfahren nach einem der Ansprüche 1 und 3 bis 13, wobei das im Schritt c) befreite Plättchen (8) aus einem Teil der geätzten ersten Siliziumschicht (2) gebildet wird.

15. Verfahren nach einem der Ansprüche 1 und 3 bis 14, wobei im Schritt b) eine Einkerbung in die erste Siliziumschicht (2) geätzt wird, um den Umfang des im Schritt c) zu befreienden Plättchens (8) zu definieren.

16. Verfahren nach einem der Ansprüche 1 und 3 bis 15, wobei im Schritt b) Öffnungen (16) in die erste Siliziumschicht (2) um eine zentrale Zone (17) geätzt werden, wo die Uhrenkomponenten (18) geätzt werden, wobei diese Öffnungen (16) während des Schritts c) den Durchgang eines Ätzmittels zum Ätzen der Siliziumoxid-Zwischenschicht (4) ermöglichen.

17. Verfahren nach einem der Ansprüche 1 bis 16, wobei die Uhrenkomponenten mindestens einen von den folgenden Komponententypen umfassen: Spiralen (18), Anker, Räder, Zeiger, Wippen, Hebel, Federn, Unruhen oder Teile solcher Komponenten.

## Claims

1. A method of manufacturing timepiece components comprising the following steps:
a) providing a substrate (1) comprising a first silicon layer (2), a second silicon layer (3) and, in between, an intermediate silicon oxide layer (4),
b) etching the first silicon layer (2) to form therein the timepiece components,
c) releasing from the substrate (1) a wafer (8) formed by at least all or part of the etched, first silicon layer (2) and comprising the timepiece components,
d) thermally oxidizing and then deoxidizing the timepiece components,
e) forming by thermal oxidation or deposition a silicon oxide layer (10) on the timepiece components, and
f) detaching the timepiece components from the wafer (8).

2. A method of manufacturing timepiece components comprising the following steps :
a) providing a substrate (20) comprising silicon layers interleaved with silicon oxide layers,
b) etching a group of layers of the substrate to form therein the timepiece components,
c) releasing from the substrate a wafer formed by at least all or part of the group of layers and comprising the timepiece components,
d) thermally oxidizing and then deoxidizing the timepiece components,
e) forming by thermal oxidation or deposition a silicon oxide layer on the timepiece components, and
f) detaching the timepiece components from the wafer.

3. A method according to claim 1 or 2, wherein the etching in step b) comprises a deep reactive ion etching.

4. A method according to any of claims 1 to 3, comprising between steps d) and e) an additional step consisting of thermally oxidizing and then deoxidizing the timepiece components.

5. A method according to claim 4, wherein step d) serves to improve the surface finish of the timepiece components and said additional step serves to adjust the stiffness of hairsprings constituting the timepiece components.

6. A method according to claim 4 or 5, wherein during the thermal oxidation operation of said additional step the wafer (8) is in an inverted position with respect to the thermal oxidation operation of step d).

7. A method according to any of claims 4 to 6, wherein during step e) the wafer (8) is in an inverted position with respect to the thermal oxidation operation of said additional step.

8. A method according to any of claims 1 to 7, wherein during the thermal oxidation operation(s) the wafer (8) is supported by a support member (11, 12, 13) comprising a support plate (11) and spacers (12) and retaining elements (13) carried by the support plate (11), the spacers (12) maintaining a gap between the wafer (8) and the support plate (11), the retaining elements (13) preventing the wafer (8) from moving horizontally.

9. A method according to claim 8, wherein the spacers (12) support the wafer (8) in areas of the wafer (8) not comprising any timepiece component.

10. A method according to claim 8 or 9, wherein the support plate (11) is made of silicon, quartz or silicon carbide.

11. A method according to any of claims 8 to 10, wherein the spacers (12) and the retaining elements (13) are made of quartz or silicon carbide.

12. A method according to any of claims 8 to 11, wherein the spacers (12) and the retaining elements (13) are fixed to the support plate (11) by bayonet-type connections.

13. A method according to any of claims 1 and 3 to 12, wherein step c) comprises an operation of vapor-phase etching the intermediate silicon oxide layer (4).

14. A method according to any of claims 1 and 3 to 13, wherein the wafer (8) released in step c) is formed by a part of the etched, first silicon layer (2).

15. A method according to any of claims 1 and 3 to 14, wherein in step b) a groove is etched in the first silicon layer (2) in order to define the peripheral edge of the wafer (8) to be released in step c).

16. A method according to any of claims 1 and 3 to 15, wherein in step b) openings (16) are etched in the first silicon layer (2) around a central area (17) where the timepiece components (18) are etched, these openings (16) allowing the passage of an etching agent for etching the intermediate silicon oxide layer (4) during step c).

17. A method according to any of claims 1 to 16, wherein the timepiece components comprise at least one of the following types of components: hairsprings (18), anchors, wheels, hands, rockers, levers, springs, balances, or parts of such components.
